# EUROPEAN PATENT APPLICATION

(11) **EP 4 610 703 A1**
(43) Date of publication of application: **03.09.2025**
(21) Application number: 25156674.1
(22) Date of filing: 07.02.2025
(51) Int. Cl.: G02B 6/42, H01S 5/022, H01S 5/023

(54) **OPTICAL FIBRE INTERFACES FOR PHOTONIC CHIPS**

(30) Priority: 09.02.2024 GB 202401810
(71) Applicant: Aegiq Ltd, Sheffield S1 2NS (GB)
(72) Inventor: Foster, Andrew, Sheffield, S1 2NS (GB); Ovenden, Charlotte, Sheffield, S1 2NS (GB); Dufferwiel, Scott, Sheffield, S1 2NS (GB); Gillard, George, Sheffield, S1 2NS (GB)
(74) Representative: Barker Brettell LLP

(57) **Abstract**

A method of producing a photonic chip and optical fibre assembly comprises: providing semiconductor wafer; etching an area (12) of the wafer to leave a mesa (14) at least partially surrounded by the etched area, and a surrounding area (20) separated from the mesa by the etched area; forming a plurality of photonic devices (16) on the mesa; forming alignment structures (18) on the surrounding area; providing an optical fibre array (22) comprising a plurality of optical fibres (24), the optical fibres including a plurality of alignment fibres (24b); positioning the optical fibre array (22) to provide an initial alignment of the alignment fibres with the alignment structures (18); transmitting an optical signal through at least one of the alignment fibres (24b) so that it interacts with at least one of the alignment structures (18); detecting a return signal from at least one of the alignment fibres (24); and adjusting the position of the array (22) based on the return signal to align the alignment fibres (26b) with the alignment structures (18).

## Description

### Field of the Invention

The present invention relates to photonic chips and in particular to the connection of optical interfaces to photonic chips.

### Background to the Invention

Semiconductor optoelectronic chips are designed to create and/or manipulate light within photonic devices which have a typical footprint measured in the square microns. Optical control of, and extraction of light from, the devices requires an optical interface with the outside world; this commonly takes the form of a linear array of optical fibres, positioned strategically above the chip. The fibre array needs to be aligned accurately with the photonic devices before it is connected to, or fixed in position relative to, the chip.

A semiconductor chip may have a p-i-n or similar structure which forms an out-of-plane diode, and has electrically active regions realised as individual diode mesas formed in the chip. Photonic devices on the chip are typically fabricated within the confines of the diode mesa structures. Optical packaging of devices on the chip typically uses a multi-fibre array, such as a linear v-groove array (VGA), positioned above the devices. The alignment of the fibre array with the devices is typically achieved using an optical feedback signal, which is transmitted between the optical fibres and the devices and therefore varies with the alignment between the fibres and the devices, to optimise the position and rotation angle of the array relative to a row of devices. However, any specific device is not guaranteed to provide a useful signal for alignment. The alignment accuracy can therefore be lower than is desirable, and the repeatability of the process affected.

If the photonic devices lack a clear spectral signature to indicate good alignment of the array, dedicated structures must be added to the row of photonic devices to enable alignment of the array. At a minimum, this requires two fibres, typically one at each end of the array, and two dedicated alignment structures, typically one at each end of the row of devices, to be dedicated to the alignment process. The alignment structures may be separate devices, or may be opposite ends of a single device, such as opposite ends of a single waveguide.

The size of each mesa on a photonic chip is generally minimised for electrical reasons. For example, a row of 6 photonic devices separated by 127µm (the fibre-fibre spacing of the array) and with a small amount of padding on either side, requires a mesa of ~700µm width. As this is already on the upper limit of the acceptable mesa width, there is a trade-off between the need to place as many photonic devices on the mesa as possible, and the need to use some of those devices for alignment of the fibre array.

### Summary of the Invention

The present invention provides a method of producing a photonic chip comprising: providing a semiconductor wafer;
etching an area of the wafer to leave a mesa at least partially surrounded by the etched area, and a surrounding area separated from the mesa by the etched area;
forming a plurality of photonic devices on the mesa;
forming alignment structures on the surrounding area;
providing an optical fibre array comprising a plurality of optical fibres, the optical fibres including a plurality of alignment fibres;
positioning the optical fibre array to provide an initial alignment of the alignment fibres with the alignment structures;
transmitting an optical signal though at least one of the alignment fibres and detecting a return signal from at least one of the alignment fibres; and
adjusting the position of the array based on the return signal.

The plurality of optical fibres may also include a plurality of interface fibres arranged for alignment with the photonic devices. The alignment fibres may be those at each end of the array.

The method may further comprise forming an electrode on the mesa. It may further comprise forming an electrode on the etched area. The electrodes may be formed before the photonic devices.

The present invention further provides a photonic chip comprising: a semiconductor wafer; wherein the wafer has a mesa formed thereon, an etched area at least partially surrounding the mesa, and a surrounding area separated from the mesa by the etched area; a plurality of photonic devices on the mesa; and a plurality of alignment structures on the surrounding area.

At least one of the alignment structures may comprise a waveguide. It may further comprise a first coupler arranged to couple light from one of the alignment fibres into the waveguide. It may further comprise a second coupler arranged to couple light from the waveguide into one of the alignment fibres. The couplers may comprise grating couplers, or any other suitable coupling mechanism that enables light to propagate between the optical fibre and the waveguide. Alternatively at least one of the alignment structures may comprise a reflective marker, which may have a defined spectral signature in reflection, such as a metallic circle patterned on the chip surface.

The photonic devices may be formed in a linear array, which may have a regular spacing. The spacing between the first and second couplers may be equal to the spacing between adjacent photonic devices in the linear array. The spacing of the optical fibre array may be equal to the spacing of the photonic devices in the linear array.

The method may further comprise fixing the optical fibre array to the wafer, for example using adhesive.

The optical fibre array may have an end face through which light can exit or enter the optical fibre array, and fixing areas which are recessed back from the end face to accommodate adhesive such as epoxy. Fixing the optical fibre array to the wafer may comprise fixing the fixing areas to respective fixing areas on the wafer using adhesive such as epoxy.

The fixing areas on the wafer may be in the surrounding area of the wafer. The method may further comprise etching a second area of the wafer to leave a second mesa at least partially surrounded by the second etched area. The method may further comprise forming further photonic devices on the second mesa. The optical fibre array may further include interface optical fibres arranged for alignment with the photonic devices on the second mesa. Further alignment structures may be formed between the two mesas. Alternatively there may be no alignment structures between the two mesas. This can allow the mesas to be more closely spaced from each other. For example the etched areas surrounding the two mesas may be separated by a separation distance which is less than the spacing between the photonic devices.

The method or system may further comprise any one or more features of the preferred embodiments of the invention as will now be described by way of example only with reference to the accompanying drawings.

### Brief Description of the Drawings

**Figure 1** is a schematic view of a photonic chip and a linear fibre array before alignment;
**Figure 2** is a schematic view of the photonic chip and linear fibre array of Figure 1 after alignment;
**Figure 3** is an exploded view of an optical fibre array forming part of an embodiment of the invention;
**Figure 4** is an end view of the fibre array of Figure 3;
**Figure 5** is a schematic side view of part of the array of Figure 3;
**Figure 6** is a top view of part of a photonic chip according to another embodiment of the invention;
**Figure 7** is a section on line A - A of Figure 6;
**Figure 8** is a section on line B - B of Figure 6;
**Figure 9** is a schematic view of an alignment device forming part of the photonic chip of Figure 6;
**Figure 10** shows a first step in the alignment of an optical fibre array with the chip of Figure 6;
**Figure 11** shows a second step in the alignment of an optical fibre array with the chip of Figure 6;
**Figure 12** shows a third step in the alignment of an optical fibre array with the chip of Figure 6;
**Figure 13** is a schematic view of a photonic chip according to a further embodiment of the invention; and
**Figure 14** is a schematic view of a photonic chip according to a further embodiment of the invention.

### Detailed Description

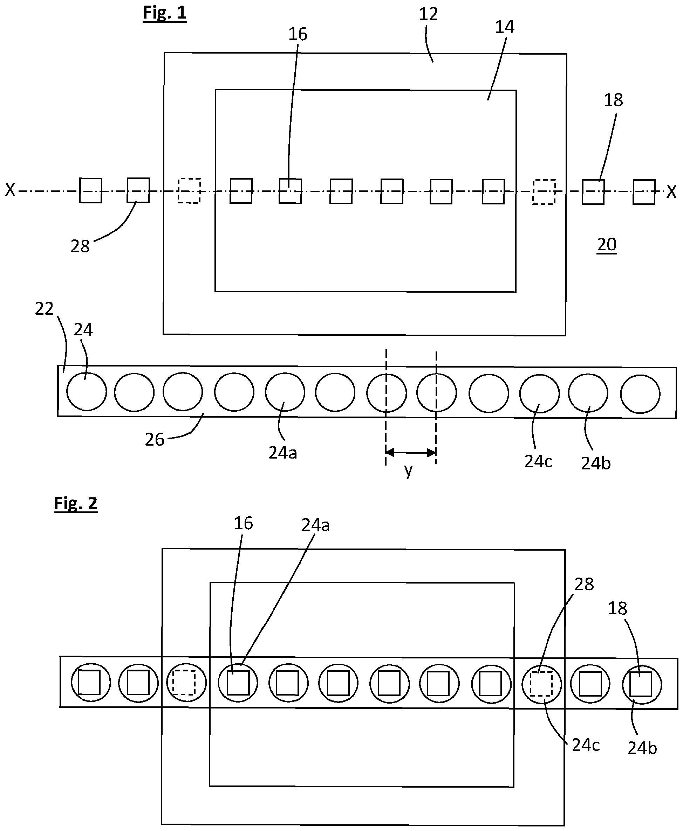

Referring to Figure 1, a photonic chip comprises a semiconductor wafer, for example having a p-i-n structure, with a part 12 of its surface etched away to leave a mesa 14 surrounded by the etched area 12. A plurality of photonic devices 16 are formed on the mesa 14. A plurality of alignment structures 18 are formed on a further area 20 of the wafer which is outside the etched area and therefore separated from the mesa 14 by the etched area 12. An optical fibre array 22 comprises a plurality of optical fibres 24 supported in a support structure 26. The optical fibres 24 may be arranged in a linear array, for example in a V-groove array as will be described in more detail below, with a constant linear spacing y between the centres of adjacent fibres 24 in the array 22. The photonic devices 16 on the mesa 14 and the alignment structures 18 are arranged in a linear array, along an axis X - X, with a spacing to match the spacing y of the optical fibre array 22 so that each of the photonic devices 16 and each of the alignment structures 18 can be aligned with one of the optical fibres 24 in the array 22. Depending on the width of the etched area 12 of the chip and the spacing of the photonic devices 16 and optical fibres 24, the spacing between the photonic device 16 at one end of the row of devices 16, i.e. the photonic device closest to the etched area 12, and the alignment structure 18 closest to that photonic device on the opposite side of the etched area, may be twice the spacing between adjacent photonic devices 16 on the mesa 14. This leaves a gap 28 in the array of photonic device and alignment structure positions, typically within the etched area 12, where no photonic device or alignment structure is present. Therefore some 24a of the fibres 24 in the array 22 are arranged to form an interface for the photonic devices 16 on the mesa 14, some of the fibres 24b in the array 22 are alignment fibres arranged to be used together with the alignment structures 18 to align the array 22 with the chip, and some of the fibres 24c in the array 22 are unused, or may be omitted altogether.

Referring to Figure 2, when the optical fibre array 22 is aligned with the chip, the interface optical fibres 24a are each aligned with one of the photonic devices 14 on the mesa 14, and the alignment fibres 24b are aligned with the alignment structures 18 on the area 20 surrounding the mesa 14. Further fibres 24c, or gaps in the array 22 where fibres are omitted, may also be aligned with the etched region 12 of the chip, for example with the locations 28 in the linear array of devices and structures on the chip where no photonic devices or structures are present.

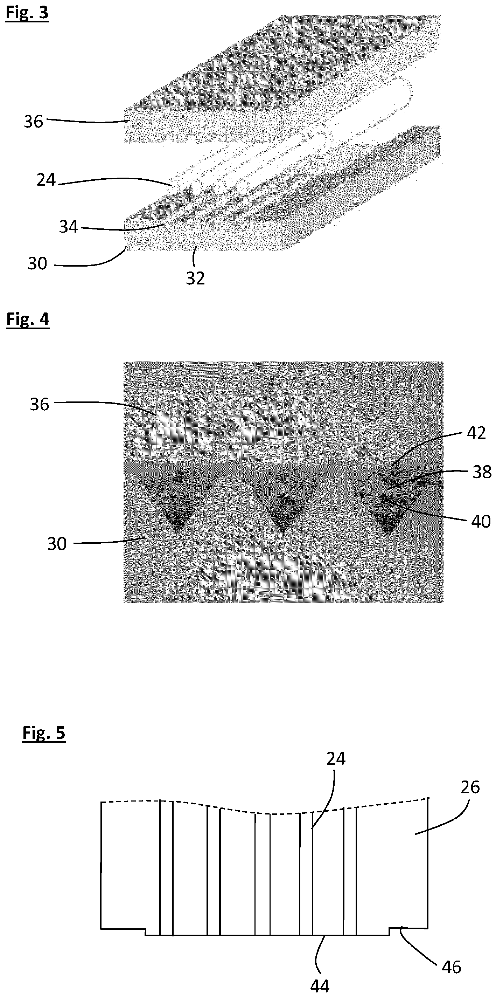

Referring to Figures 3 and 4, the optical fibre array 22 may be a v-groove array in which the support structure 26 comprises a v-groove base 30, i.e. a support layer 32 with a number of parallel v-section grooves 34 formed in its surface, and a lid 36, with the optical fibres 24 located in the grooves 34 and the lid 36 retaining the fibres 24 within the grooves 34. The optical fibres 24 can take any suitable form, and referring to Figure 4 may be polarization maintaining fibres comprising a core 38 and stress rods 40 locate within a cladding 42. Referring to Figure 5, the support structure 26 of the optical fibre array 22 may have an end face 44, which is level with the ends of the optical fibres 24, and may be in a plane perpendicular to the axes of the optical fibres, through which light can exit or enter the array 22, and epoxy contact areas 46 which are recessed back from the end face 44, for example by a distance of the order of 10 microns, and are arranged to contact a layer of epoxy which is placed between them and the surface of the wafer, typically in the area 22 outside the mesa 14 and the etched area 12, so as to be connected to the wafer with the epoxy. This ensures a firm epoxy connection between the epoxy contact areas 46 of the array 22 and the wafer, while allowing the ends of the optical fibres 24 to be located close enough to the photonic devices 16 for the efficient transmission of light between the fibres 24 and the photonic devices 16.

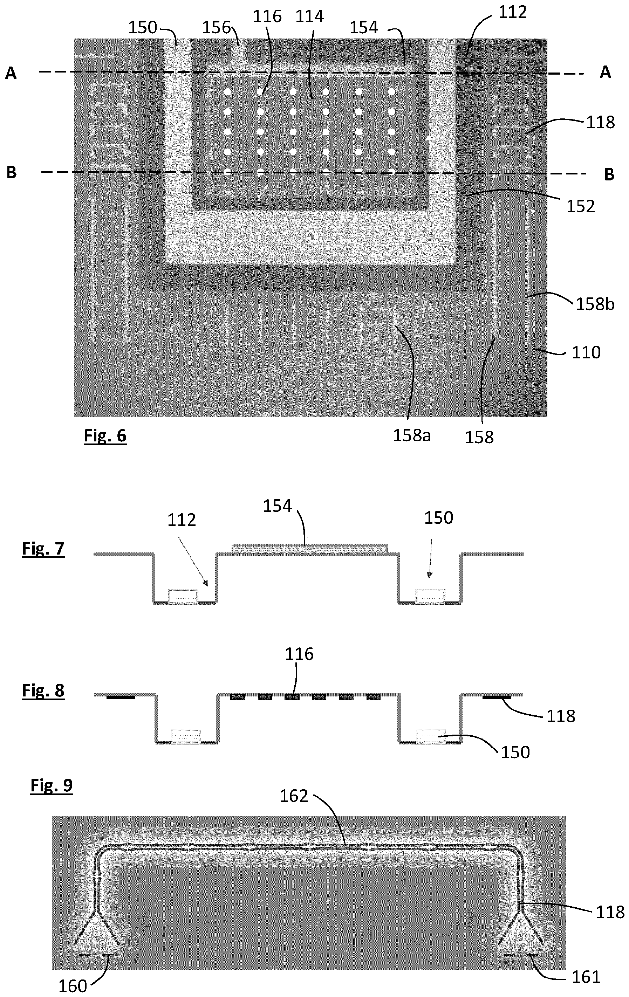

Referring to Figures 6 to 8, in which features corresponding to those in Figures 1 to 5 are indicated by the same reference numerals increased by 100, the etched area 112 of the wafer 110 may have a first electrode 150 formed on the bottom surface 152 of the trench formed by the etching, and the mesa 114 may have a second electrode 154 formed on it. These electrodes 150, 154 may be connected to electrical contact pads (not shown in Figure 6) for example by conductors 156. The electrodes 150, 154 are used to contact the diode, formed by the p-i-n structure of the chip, which is used to apply an electrical potential across the photonic devices 116 on the mesa 114.

There may be several rows, or linear arrays, of photonic devices 116. Each row of photonic devices 116 may have associated alignment structures 118, aligned with the devices 116 in the row on a common axis, but located outside the etched area 112 as in the arrangement of Figures 1 and 2. This results in a rectangular array of photonic devices 116 on the mesa 114, with a linear array of alignment structures 118 on either side of the mesa 114. Reflective alignment markers 158, for example of gold, may be provided on the wafer 110 on the area surrounding the etched area 112, to aid with initial alignment of the optical fibre array 22. These markers 158 may be in the form of lines 158a, perpendicular to the axis of each of the rows of photonic devices, and each aligned with one of the devices from each of the rows. They may also include lines 158b aligned with each of the linear arrays of alignment structures 118. This means that an array of optical fibres which is arranged to align with the optical devices 116 and alignment structures 118 can also be aligned with the markers 158 for initial alignment of the optical fibre array 22. Gold may be selected as it is highly reflective, but other reflective materials may be used.

As shown in more detail in Figure 9, the alignment structures 118 may each comprise a pair of grating couplers 160, 161 interconnected by a waveguide 162. As is well known, one of the grating couplers 160, 161 can be optimised to couple light of a particular frequency range which is incident on it, for example from one of the optical fibres in the optical fibre array, into the waveguide 162, and the other grating coupler 161 can be optimised to transmit light of the same frequency range from the waveguide out, for example into one of the optical fibres of the optical fibre array.

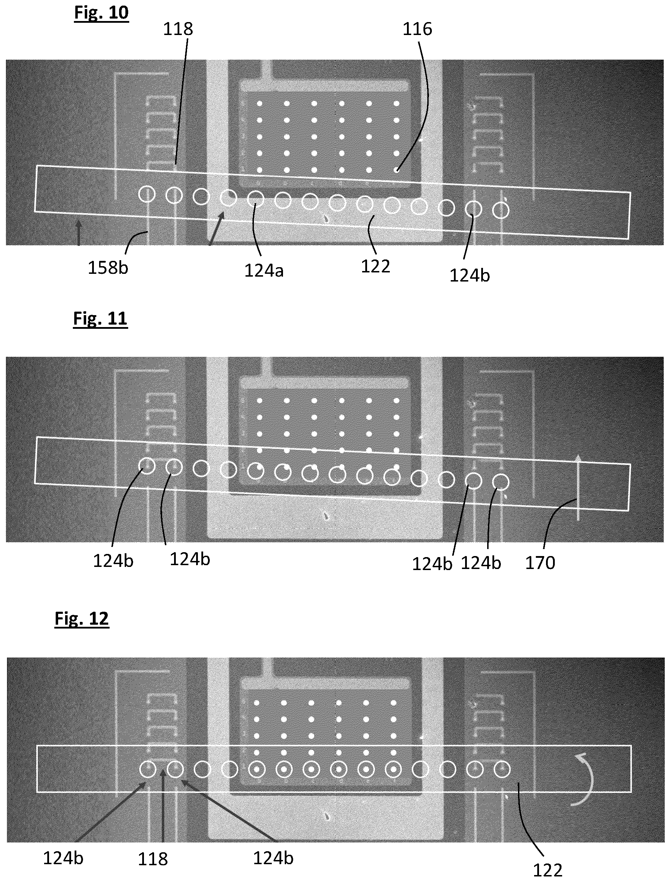

Referring to Figure 10, a first step in aligning the optical fibre array 122 with the optical devices 116 may comprise bringing the end face of the optical fibre array 122 gently into contact with the chip, at a position away from the devices, to ensure that the optical fibre array is parallel to the surface of the chip. The optical fibre array 122 is then lifted vertically a few microns away from the surface of the chip and then moved laterally or rotationally to align some of the optical fibres 124 with the alignment markers 158. The array 122 is held and manipulated by a six-axis manipulation stage (not shown) which includes light sources arranged to transmit light into the optical fibres 124, and detectors arranged to detect light returned through the optical fibres thereby to measure the degree of alignment of the fibres with the alignment markers 158 and alignment structures 118 on the chip. For example light may be transmitted down the alignment fibres 124b and the light reflected back up the same fibres measured. A maximum level of reflected light, or in some cases the spectral content of the reflected light, is indicative of the alignment fibres being aligned with the markers 158b. Referring back to Figure 6, since there may also be alignment markers 158a arranged for alignment with the interface optical fibres 124a of the array 22, those markers may be used as well as, or instead of, the markers 158b which are arranged for alignment with the alignment fibres 124b.

Referring to Figure 11, after the initial alignment of the optical fibre array 122 using the alignment markers 158, the light transmission and measurement mode of the manipulation stage may be modified for interaction with the alignment structures 118. For example light may be transmitted down one of the alignment fibres 124b at each end of the fibre array, and light transmitted from the other of the two alignment fibres at each end of the array measured, to determine the degree of alignment of the fibres with the alignment structures 118 on the chip. The fibre array is then moved in the direction of the arrow 170 so that the alignment fibres 124b move towards the alignment structures 118. If the two alignment fibres 124a at one end of the array 122 become aligned with a pair of grating couplers of one of the alignment formations 118, then light transmitted down one of those fibres 124a will be coupled into the waveguide between the two grating couplers, transmitted along the waveguide, and then transmitted out of the other grating coupler into the other of the alignment fibres 124a. The return optical signal can then be detected, and the movement of the optical fibre array 122 continued until the detected return optical signal is maximised.

Referring to Figure 11 and Figure 12, if a return optical signal is detected, or maximised, at one side of the optical fibre array 122 but not the other, this suggests that rather than pure lateral movement of the array 122, rotation is required so as to align the alignment fibres 124b on both sides of the array with the appropriate alignment structures 118. Once the alignment is achieved, the array 122 is moved into contact with the chip and connected to the chip using adhesive for example on fixing pads on the array as described above with reference to Figure 5.

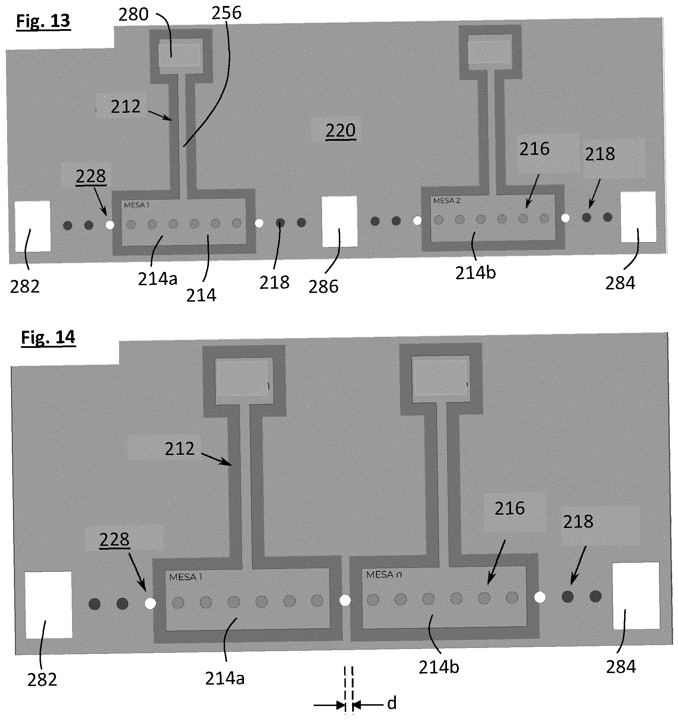

Referring to Figure 13, a chip typically includes a large number of mesas 214, and a single optical fibre array may be arranged for alignment with photonic devices 216 on two adjacent mesas 214a, 214b. Each of the mesas 214a, 214b will typically have an electrode on it similar to that of Figure 7, connected to an electrical contact pad 280 via a connector 256, and the etched area 212 around each of the mesas 214a, 214b also extends around the associated connector 256 and contact pad 280. In order for a single optical fibre array to be used with devices on both mesas 214a, 214b, each of the mesas has a linear array of photonic devices 216 on it, and the arrays on the two mesas are aligned with each other to form a single linear array. Alignment structures 218 are again provided on the area 220 of the chip outside the etched areas 212. These alignment structures are also aligned with the linear array of photonic devices in a single linear array of positions. This linear array has a regular spacing, but some of the positions 228 in the regular linear array are empty in that there are no photonic devices or alignment structures at them. If sufficient space is provided between the two mesas 214a, 214b, then one or more alignment structures may be provided between the mesas. Furthermore, if there is sufficient space between the mesas 214a, 214b, as well as fixing areas 282, 284 arranged for fixing a single optical fibre array extending across both mesas 214a, 214b,a third fixing area 286, arranged to support one end of a shorter optical fibre array over just one of the mesas 214a, 214b, may be provided between the mesas 214a, 214b.

Referring to Figure 14, if the mesas 214a, 214b are closer together there may be no room between them for any of the alignment structures 218 or fixing areas between them, so the alignment structures 218 and fixing areas 282, 284 are located beyond the outer ends of the two mesas 214a, 214b, so that the optical fibre array has a single span over both mesas. For example the gap d between the etched areas surrounding the tow mesas 214a, 214b may be less than the spacing of the photonic devices 216.

It will be appreciated that various modifications can be made to the embodiments shown in the drawings. For example, where the alignment structures each comprise a pair of grating couplers linked by a waveguide, the orientation of the structure can be different from that described above. For example the two grating couplers may be offset from each other in a direction perpendicular to the axis of the linear array of photonic devices. This would make the structure of the optical fibre array more complex but might have packaging benefits in some situations. Alternatively the alignment structures may take other forms altogether. For alignment to be based on variation of a return optical signal it is only necessary that the return optical signal varies with the position of the optical fibre array relative to the alignment structure. As a simple example the alignment structures may be reflective dots, for example of gold similar to the alignment markings 158 described above. In that case, the alignment process is carried out by transmitting an optical signal down one of the optical fibres 24 and measuring the reflected light received back from the same optical fibre. The reflected signal is maximised when the optical fibre is aligned with the dot.

Some embodiments of the invention may have various advantages. The alignment structures do not have to lie in an electrically active region and can therefore lie outside the mesa. The mesa size can be dictated by the number, spacing and dimensions of photonic devices only, and is not affected by the alignment structures. The alignment accuracy can be improved relative to a system without dedicated alignment markers, due to better control of angular alignment with increasing VGA length, and a clearer feedback signal from the dedicated alignment structures. The alignment process allows greater flexibility in the photonic device design.

## Claims

1. A method of producing a photonic chip and optical fibre assembly, the method comprising:
providing a semiconductor wafer;
etching an area of the wafer to leave a mesa at least partially surrounded by the etched area, and a surrounding area separated from the mesa by the etched area;
forming a plurality of photonic devices on the mesa;
forming alignment structures on the surrounding area;
providing an optical fibre array comprising a plurality of optical fibres, the optical fibres including a plurality of alignment fibres;
positioning the optical fibre array to provide an initial alignment of the alignment fibres with the alignment structures;
transmitting an optical signal through at least one of the alignment fibres so that it interacts with at least one of the alignment structures;
detecting a return signal from at least one of the alignment fibres; and
adjusting the position of the array based on the return signal to align the alignment fibres with the alignment structures.

2. A method according to claim 1 wherein the plurality of optical fibres also include a plurality of interface fibres arranged for alignment with the photonic devices.

3. A method according to claim 1 or claim 2 wherein at least one of the alignment structures comprises a waveguide, a first coupler arranged to couple light from one of the alignment fibres into the waveguide, a second coupler arranged to couple light from the waveguide into one of the alignment fibres.

4. A method according to claim 3 wherein the photonic devices are formed in a linear array and the spacing between the first and second couplers is equal to the spacing between adjacent photonic devices in the linear array.

5. A method according to claim 4 wherein the spacing of the optical fibre array is equal to the spacing of the photonic devices in the linear array.

6. A method according to any preceding claim further comprising fixing the optical fibre array to the wafer.

7. A method according to claim 6 wherein the optical fibre array has an end face through which light can exit or enter the optical fibre array, and epoxy contact areas which are set back from the end face, and fixing the optical fibre array to the wafer comprises fixing the epoxy contact areas to respective fixing areas on the wafer.

8. A method according to claim 7 wherein the fixing areas are in the surrounding area of the wafer.

9. A method according to claim 8 further comprising etching a second area of the wafer to leave a second mesa at least partially surrounded by the second etched area, and forming further photonic devices on the second mesa, wherein the optical fibre array includes interface optical fibres arranged for alignment with the photonic devices on the second mesa.

10. A method according to claim 9 wherein further alignment structures are formed between the two mesas.

11. A method according to claim 9 where there are no alignment structures between the two mesas.

12. A method according to claim 11 wherein the etched areas surrounding the two mesas are separated by separation distance which is less the spacing between the photonic devices.

13. A photonic chip comprising:
a semiconductor wafer; wherein the wafer has a mesa formed thereon, an etched area at least partially surrounding the mesa, and a surrounding area separated from the mesa by the etched area;
a plurality of photonic devices on the mesa; and
a plurality of alignment structures on the surrounding area.

14. A photonic chip according to claim 13 wherein at least one of the alignment structures comprises a waveguide, a first coupler arranged to couple light from one of the alignment fibres into the waveguide, a second coupler arranged to couple light from the waveguide into one of the alignment fibres.

15. A photonic chip according to claim 14 wherein the photonic devices are formed in a linear array and the spacing between the first and second couplers is equal to the spacing between adjacent photonic devices in the linear array.
